Europäisches Patentamt

European Patent Office

Office européen des brevets

(11) Numéro de publication: **0 069 634**
**B1**

(12) **FASCICULE DE BREVET EUROPEEN**

(45) Date de publication du fascicule du brevet: **10.06.87**

(21) Numéro de dépôt: **82401163.9**

(22) Date de dépôt: **24.06.82**

(51) Int. Cl.⁴: **H 01 L 29/90**, H 01 L 29/167, H 01 L 21/26

(54) **Diode Zener compensée en température et stable sous irradiation et procédé de fabrication d'une telle diode.**

(30) Priorité: **30.06.81 FR 8112846**

(43) Date de publication de la demande:
**12.01.83 Bulletin 83/02**

(45) Mention de la délivrance du brevet:
**10.06.87 Bulletin 87/24**

(84) Etats contractants désignés:
**DE GB**

(56) Documents cités:
**US-A-3 440 113**
**US-A-3 953 254**

(73) Titulaire: **COMMISSARIAT A L'ENERGIE ATOMIQUE Etablissement de Caractère Scientifique Technique et Industriel 31/33, rue de la Fédération F-75015 Paris (FR)**

(72) Inventeur: **Champon, Jacques 121, rue Juliette Savar F-94000 Creteil (FR)**
Inventeur: **Maurice, Bruno Résidence de Surville Sud No 27 F-13510 Eguilles (FR)**
Inventeur: **Roumeguere, Michel 2bis, rue Terre Marnée F-91190 Gif Sur Yvette (FR)**

(74) Mandataire: **Mongrédien, André et al c/o BREVATOME 25, rue de Ponthieu F-75008 Paris (FR)**

Courier Press, Leamington Spa, England.

EP 0 069 634 B1

## Description

La présente invention concerne une diode Zener compensée en température et un procédé de fabrication d'une telle diode, cette diode étant apte notamment à fonctionner sous irradiations telles que des irradiations neutroniques.

On sait qu'une diode est un composant électronique constitué d'un matériau semi-conducteur comprenant une région de type N et une région de type P. L'association d'une région de type N et d'une région de type P est connue sous l'expression de jonction PN.

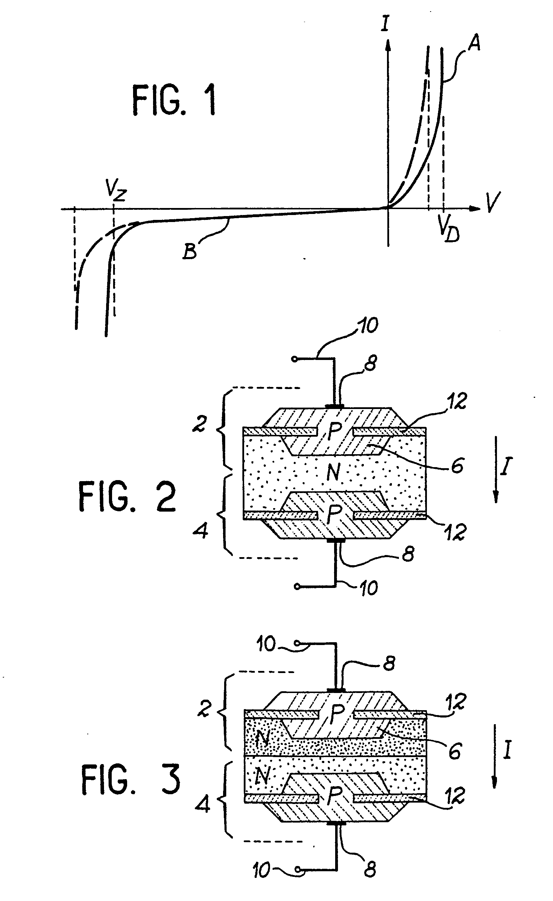

Sur la figure 1, on a représenté en trait plein la caractéristique d'une diode, c'est-à-dire, la courbe donnant le courant électrique I en fonction de la tension V. On constate que la diode présente deux régimes de fonctionnement possibles selon le sens de parcours du courant qui la traverse.

La partie A de la caractéristique correspond au fonctionnement en direct, c'est-à-dire que le courant entre dans la diode par la région P, et la partie B de la caractéristique correspond au fonctionnement en inverse, c'est-à-dire que le courant entre dans la diode par la région N.

Sur la partie A de la caractéristique, la tension croît rapidement en fonction du courant jusqu'à atteindre une valeur $V_D$ au-dessus de laquelle la tension varie peu. En général, la valeur de la tension $V_D$ est comprise entre 0,5 volt et 1 volt.

Sur la partie B de la caractéristique, le courant reste pratiquement nul jusqu'à ce que la tension atteigne une certaine valeur notée $V_z$, appelée tension Zener ou d'avalanche, au-dessus de laquelle le courant croît très rapidement.

Une diode Zener compensée en température, connue sous l'expression abrégée de diode ZCT, est un composant semi-conducteur dont la fonction est de réaliser une référence de tension, c'est-à-dire qu'elle permet de garantir une tension stable quelles que soient les conditions d'environnement et notamment la température, la variation d'alimentation, l'irradiation neutronique, etc.

Son principe consiste à mettre en opposition deux jonctions PN, l'une fonctionnant en inverse, l'autre en direct. On aboutit ainsi à une dérive de la tension minimisée en température qui résulte d'un ajustement entre la dérive positive au rapport $dV_z/dT$ de la jonction fonctionnant en inverse ou jonction Zener et la dérive négative ou rapport $dV_D/dT$ de la jonction fonctionnant en direct, ce rapport étant relativement peu dépendant de la tension $V_D$, c'est-à-dire de l'ordre de $-1,5°C$ pour une tension $V_D$ d'environ 0,6 à 0,7 volt. En revanche, pour obtenir une variation $dV_z/dT$ du même ordre de grandeur (mais positive), il faut nécessairement une valeur de la tension Zener $V_z$ d'environ 5,5 à 5,6 volts. Ceci conduit à une tension totale du dispositif compensé en température d'environ 6,1 à 6,3 volts.

Toute la technologie de réalisation d'une diode compensée en température doit donc s'employer à concevoir deux jonctions PN dont les régimes de fonctionnement sont très différents mais dont les dérives en température sont proches l'une de l'autre en valeur absolue. A titre indicatif, la dérive en température d'une jonction fonctionnant en inverse pour $V_z$ égale à 5,5 volts est de l'ordre de $2.10^{-4}/°C$. La compensation par une jonction PN fonctionnant en direct doit permettre de ramener cette dérive à une valeur au plus égale à $10^{-5}/°C$.

Parmi les procédés de fabrication d'une diode Zener compensée en température, connus jusqu'à ce jour, il en est un qui consiste à réaliser des jonctions PN (ou diodes Zener) par épitaxie, c'est-à-dire que la région P est déposée sur un substrat de type N par l'intermédiaire d'un gaz vecteur à base d'iode, puis à recuire ces jonctions. Ce mode de réalisation a l'avantage d''''enterrer'' la partie active de la jonction PN loin des perturbations de surface, d'où une bonne fiabilité et une bonne reproductibilité, ce qui permet d'obtenir des diodes de bonne qualité. Les principaux paramètres de fabrication sont alors la résistivité du substrat de départ qui est liée à la concentration des particules dopantes de la région N, les durées et tempértatures des différentes opérations de recuit.

L'assemblage complet de la diode ZCT est conçu à partir du procédé décrit ci-dessus et de manière monolithique, c'est-à-dire que les deux jonctions PN sont réalisées sur un même substrat de type N, ce qui procure à leur liaison un couplage thermique idéal. Pour de plus amples détails sur la réalisation d'une telle diode ZCT, on peut se référer au brevet français FR—A—1522532 déposé le 17 mars 1967 par la société Sescosem et intitulé "Perfectionnements aux diodes Zener".

Sur la figure 2, on a représenté une telle diode ZCT. La partie 2 correspond approximativement à la jonction PN fonctionnant en direct, la flèche I donnant le sens du courant traversant la diode, et la partie 4 à la jonction PN fonctionnant en inverse ou en Zener. La région référencée 6 représente la région active enterrée de la jonction PN. Cette diode ZCT est, de plus, munie de deux couches conductrices 8 déposées au-dessus des deux régions P desquelles partent des fils de connexions 10 permettant de relier électriquement la diode ZCT à différents circuits électriques, et de deux couches isolantes référencées 12 déposées sur une partie des deux régions N.

Cependant, une telle diode ZCT subit de grands dommages lorsqu'elle est soumise à une irradiation neutronique. En particulier, ceci entraine des modifications dans sa courbe caractéristique. Ces modifications ont été représentées en pointillé sur la figure 1.

On constate que la tension $V_D$ diminue fortement tandis que la coefficient de température $dV_D/dT$ augmente en valeur absolue. Par ailleurs, la tension Zener $V_z$ augmente tandis que le coefficient de température $dV_z/dT$ diminue.

Il en résulte donc des variations importantes de la tension de référence totale ainsi que du coefficient de température.

De façon simplifiée, la dégradation des caractéristiques électriques de la diode résulte de la création de défauts ou lacunes dans le matériau semi-conducteur, suite aux bombardements neutroniques, correspondant à un déplacement des atomes constituant ledit matériau. Ces lacunes vont avoir tendance à se déplacer et à se regrouper avec d'autres impuretés formant ce qu'on appelle des défauts complexes. Ce sont ces défauts qui vont modifier les caractéristiques électriques de la diode.

L'invention a justement pour objet une diode Zener compensée en température et un procédé de fabrication d'une telle diode permettant de remédier à ces inconvénients et pouvant notamment fonctionner sous irradiation neutronique.

De façon plus précise, l'invention a pour objet un procédé de fabrication d'une diode Zener compensée en température, dans lequel on réalise une première jonction PN en déposant par épitaxie un premier substrat en silicium de type P sur un premier substrat en silicium de type N puis en la soumettant à une diffusion d'impuretés métalliques, cette diffusion étant effectuée dans la région N de ladite jonction, caractérisé en ce que l'on réalise séparément une seconde jonction PN en déposant par épitaxie un deuxième substrat en silicium de type P sur un deuxième substrat en silicium de type N ayant une concentration en impureté de type N supérieure à celle du premier substrat en silicium de type N, et en ce que l'on relie les deux jonctions PN de façon que la première jonction PN puisse fonctionner en direct et que la seconde jonction PN puisse fonctionner en inverse.

La diffusion d'impuretés métalliques permet de conserver, après irradiation neutronique de la diode Zener, obtenue selon l'invention, une précision sur la dérive en température au plus égale à $10^{-5}/°C$.

Selon un mode préféré de mise en oeuvre du procédé de l'invention, les impuretés métalliques sont des atomes d'or.

Selon un autre mode préféré de mise en oeuvre du procédé de l'invention, la diffusion des impuretés métalliques est effectuée à une température comprise entre 1 000 et 1 200°C et de préférence cette température est d'environ 1 100°C et ce, pendant environ 1 heure.

La concentration du nombre d'impuretés métalliques diffusées définit l'efficacité de la compensation en température, cette concentration étant définie par la température et la durée de la diffusion.

Selon un autre mode préféré de réalisation de l'invention, le premier substrat en silicium de type N contient $2,4\cdot10^{18}$ atomes de phosphore par centimètre cube et le second substrat en silicium de type N contient $2,8\cdot10^{18}$ atomes de phosphore par centimètre cube.

L'invention a aussi pour objet une diode Zener compensée en température, comprenant une première jonction PN comprenant une première région en silicium de type P et une première région en silicium de type N, comportant des impuretés métalliques introduites dans ladite région de type N par diffusion, et une seconde jonction PN caractérisée en ce que la seconde jonction PN comprend une seconde région en silicium de type P et une seconde région en silicium de type N, cette seconde région de type N étant obtenue par un dopage en impuretés de type N supérieur à celui qui est effectué pour la première région de type N, lesdites jonctions étant reliées l'une à l'autre de façon que la première jonction PN puisse fonctionner en direct et que la seconde jonction puisse fonctionner en inverse.

D'autres caractéristiques et avantages de l'invention apparaîtront clairement à la lecture de la description qui suit, donnée à titre purement illustratif et nullement limitatif, en référence aux figures annexées, sur lesquelles:

— la figure 1, déjà décrite, représente la caractéristique d'une diode Zener, c'est-à-dire la courbe donnant le courant I en fonction de la tension V;
— la figure 2, déjà décrite, représente une diode Zener compensée en température de l'art antérieur; et,
— la figure 3 représente une diode Zener compensée en température obtenue selon le procédé de l'invention.

Selon l'invention, le procédé de fabrication d'une diode Zener compensée en température ou diode ZCT consiste à réaliser deux jonctions PN séparément puis à les relier de façon que l'une des deux jonctions puisse fonctionner en direct et l'autre en inverse. Les deux jonctions PN sont réalisées de façon très différentes.

En ce qui concerne la jonction PN fonctionnant en direct, celle-ci est réalisée en déposant par épitaxie un substrat en silicium de type P sur un substrat en silicium de type N, puis en faisant diffuser à haute température des impuretés métalliques telles que des impuretés de platine, de fer, d'or etc. . . Etant donné que la technologie de diffusion d'or est la plus facile à maîtriser, on choisira plutôt ce type d'impuretés à tout autre. Cette diffusion d'or peut par exemple être réalisée à partir d'un eutectique or-silicium réalisé sur la région N de la jonction puis en effectuant une étape de recuit à température élevée.

Il est à noter que l'efficacité de la compensation en température sous irradiations neutroniques d'une diode ZCT dépend de la concentration des impuretés métalliques diffusées. Cette concentration dépend du temps pendant lequel est effectué le recuit ainsi que de la température à laquelle il est effectué. Par exemple ce recuit sera effectué pendant environ une heure et à une température comprise entre 1 000 et 1 200°C. Des études ont montré que la meilleure température de diffusion est d'environ 1 100°C. Ceci permet d'obtenir une concentration d'or d'environ $2\cdot10^{16}$ atomes par centimètre cube.

Les impuretés métalliques diffusées vont se substituer à des atomes de silicium constituant le substrat. Ces impuretés métalliques chargées négativement vont jouer le même rôle que les défauts complexes, créés lors d'un bombardement neutronique d'une diode ZCT de l'art antérieur, mais les défauts correspondant aux impuretés métalliques sont beaucoup plus stables.

En ce qui concerne la jonction PN fonctionnant en inverse ou jonction Zener, celle-ci peut être réalisée en déposant par épitaxie un substrat en silicium de type P sur un substrat en silicium de type N. La réalisation d'une jonction Zener par épitaxie a été décrite de façon détaillée dans le brevet français FR—A—1.522 532 précédemment cité.

Afin d'obtenir une compensation en température avec un bon rendement, la réalisation de la jonction Zener peut être complétée en lui faisant subir un léger traitement thermique. Le traitement thermique permet d'ajuster la diffusion des particules de type P dans le substrat de type N de la jonction Zener et donc d'adapter au mieux le coefficient de température de cette jonction à celui de la jonction fonctionnant en direct.

Sur la figure 3, on a représenté une diode ZCT obtenue selon le procédé de fabrication de l'invention.

Contrairement aux diodes ZCT de l'art antérieur les deux jonctions PN sont distinctes d'où la présence de deux régions N distinctes. Comme précédemment, la partie 2 correspond à la jonction PN fonctionnant en direct, le sens du courant traversant la diode étant donné par la flèche I, et la partie 4 correspond à la jonction PN fonctionnant en inverse. De même, la référence 8 correspond aux deux couches conductrices déposées au-dessus des deux régions P desquelles partent des fils de connexions 10, et la référence 12 correspond aux deux couches isolantes déposées sur une partie des deux régions N.

Des études ont montré que la nature du substrat en silicium de départ de type N, pour les deux jonctions PN, joue, comme la diffusion d'impuretés métalliques à haute température, un grand rôle en ce qui concerne la stabilité de la tension et du coefficient de température notamment sous irradiations neutroniques.

Pour obtenir une bonne compensation en température selon l'invention, le substrat de type N de la jonction PN fonctionnant en direct sera obtenu par dopage d'un substrat en silicium par exemple homogène au moyen d'atomes de phosphore de façon que ledit substrat de type N contienne 2 à $3 \cdot 10^{18}$ atomes par centimètre cube et de préférence $2,4 \cdot 10^{18}$ atomes par centimètre cube. De même, le substrat de type N de la jonction Zener sera obtenu par dopage d'un substrat en silicium au moyen d'atomes de phosphore de façon que ledit substrat de type N contienne 2 à $3 \cdot 10^{18}$ atomes par centimètre cube et de préférence $2,8 \cdot 10^{18}$ atomes par centimètre cube.

En ce qui concerne le substrat de type P celui-ci peut être obtenu, pour les deux jonctions PN, par exemple par un dopage d'un substrat en silicium par du Bore avec une concentration de l'ordre de $10^{20}$ atomes par centimètre cube et la durée pendant laquelle a lieu l'épitaxie du substrat P sur le substrat N peut être d'environ 20 minutes.

Pour des diodes Zener compensées en température obtenues selon l'invention, la dérive de la tension est d'environ 2 millivolts, après avoir soumis lesdites diodes à un flux neutronique de $10^{14}$ neutrons par centimètre carré (équivalent à 1 MeV) et la précision sur la dérivé en température de ces diodes est conservée. En général cette précision est inférieure à $10^{-5}/°C$.

**Revendications**

1. Procédé de fabrication d'une diode Zener compensée en température, dans lequel réalise une première jonction PN (2) en deposant par épitaxie un premier substrat en silicium de type P sur un premier substrat en silicium de type N puis en la soumettant à une diffusion d'impuretés métalliques, cette diffusion étant effectuée dans la region N de ladite jonction, caractérisé en ce que l'on réalise séparément une seconde jonction PN (4) en déposant par épitaxie un deuxième substrat en silicium de type P sur un deuxième substrat en silicium de type N ayant une concentration en impuretés de type N supérieure à celle du premier substrat en silicium de type N, et en ce que l'on relie les deux jonctions PN de façon que la première jonction PN puisse fonctionner en direct et que la seconde jonction PN puisse fonctionner en inverse.

2. Procédé de fabrication selon la revendication 1, caractérisé en ce que les impuretés métalliques sont des atomes d'or.

3. Procédé de fabrication selon l'une quelconque des revendications 1 et 2, caractérisé en ce que la diffusion des impuretés métalliques est effectuée à une température comprise entre 1 000 et 1 200°C.

4. Procédé de fabrication selon la revendication 3, caractérisé en ce que la température de diffusion est d'environ 1 100°C.

5. Procédé de fabrication selon l'une quelconque des revendications 3 et 4, caractérisé en ce que la durée de la diffusion est d'environ 1 heure.

6. Procédé de fabrication selon l'une quelconque des revendications 1 à 5, caractérisé en ce que le premier et le second substrats en silicium de type N sont réalisés de façon qu'ils contiennent 2 à $3 \cdot 10^{18}$ atomes de phosphore par centimètre cube.

7. Procédé de fabrication selon la revendication 6, caractérisé en ce que le premier substrat en silicium de type N contient $2,4 \cdot 10^{18}$ atomes de phosphore par centimètre cube.

8. Procédé de fabrication selon l'une quelconque des revendications 6 et 7, caractérisé en ce que le second substrat en silicium de type N contient $2,8 \cdot 10^{18}$ atomes de phosphore par centimètre cube.

9. Diode Zener compensée en température, comprenant une première jonction PN comprenant une première région en silicium de type P et une première région en silicium de type N, comportant des impuretés métalliques introduites dans ladite région de type N par diffusion, et une seconde jonction PN caractérisée en ce que la seconde jonction PN comprend une seconde région en silicium de type P et une seconde région en silicium de type N, cette seconde région de type N étant obtenue par un dopage en impuretés de type N supérieur à celui qui est effectué pour la première région de type N, lesdites jonctions étant reliées l'une à l'autre de façon que la première jonction PN puisse fonctionner en direct et que la seconde jonction PN puisse fonctionner en inverse.

10. Diode Zener selon la revendication 9, caractérisée en ce que la première région en silicium de type N contient $2,4\cdot10^{18}$ atomes de phosphore par centimètre cube.

11. Diode Zener selon l'une quelconque des revendications 9 et 10, caractérisée en ce que la seconde région en silicium de type N contient $2,8\cdot10^{18}$ atomes de phosphore par centimètre cube.

12. Diode Zener selon l'une quelconque des revendications 9 à 11, caractérisée en ce que les impuretés métalliques diffusées sont des atomes d'or.

13. Diode Zener selon la revendication 12, caractérisée en ce que la concentration des atomes d'or est de $2\cdot10^{16}$ atomes par centimètre cube.

**Patentansprüche**

1. Verfahren zur Herstellung einer Zener-Diode mit Temperaturkompensation, bei dem ein erster PN-Übergang (2) hergestellt wird, indem durch Epitaxie ein erstes Substrat aus Silicium vom Typ P auf einem ersten Substrat aus Silicium vom Typ N niedergeschlagen und daraufhin metallische Fremdatome eindiffundiert werden, wobei diese Diffusion in dem Bereich N des Übergangs durchgeführt wird, dadurch gekennzeichnet, daß man getrennt einen zweiten PN-Übergang (4) herstellt, indem durch Epitaxie ein zweites Substrat aus Silicium vom Typ P auf einem zweiten Substrat aus Silicium vom Typ N niedergeschlagen wird, welches eine größere Fremdatomkonzentration vom Typ N als diejenige des ersten Substrats aus Silicium vom Typ N aufweist, und daß man diese zwei PN-Übergänge derart verbindet, daß der erste PN-Übergang direkt und der zweite PN-Übergang umgekehrt arbeitet.

2. Herstellungsverfahren nach Anspruch 1, dadurch gekennzeichnet, daß die metallischen Fremdatome Goldatome sind.

3. Herstellungsverfahren nach Anspruch 1 oder 2, dadurch gekennzeichnet, daß die Diffusion der metallischen Fremdatome bei einer Temperatur zwischen 1000 und 1200°C durchgeführt wird.

4. Herstellungsverfahren nach Anspruch 3, dadurch gekennzeichnet, daß die Diffusionstemperatur bei ungefähr 1100°C liegt.

5. Herstellungsverfahren nach Anspruch 3 oder 4, dadurch gekennzeichnet, daß die Diffusionsdauer ungefähr 1 Stunde beträgt.

6. Herstellungsverfahren nach einem der Ansprüche 1 bis 5, dadurch gekennzeichnet, daß das erste und das zweite Substrat aus Silicium vom Typ N so hergestellt werden, daß sie 2 bis $3\times10^{18}$ Phosphoratome pro Kubikzentimeter enthalten.

7. Herstellungsverfahren nach Anspruch 6, dadurch gekennzeichnet, daß das erste Substrat aus Silicium vom Typ N $2,4\times10^{18}$ Phosphoratome pro Kubikzentimeter enthält.

8. Herstellungsverfahren nach Anspruch 6 oder 7, dadurch gekennzeichnet, daß das zweite Substrat aus Silicium vom Typ N $2,8\times10^{18}$ Phosphoratome pro Kubikzentimeter enthält.

9. Zener-Diode mit Temperaturausgleich, die einen ersten PN-Übergang, der einen ersten Bereich aus Silicium vom Typ P und einen ersten Bereich aus Silicium vom Typ N aufweist, der durch Diffusion in den Bereich vom Typ N eingebrachte, metallische Fremdatome aufweist, und einen zweiten PN-Übergang umfaßt, dadurch gekennzeichnet, daß der zweite PN-Übergang einen zweiten Bereich aus Silicium vom Typ P und einen zweiten Bereich aus Silicium vom Typ N aufweist, wobei der zweite Bereich vom Typ N durch eine höhere Dotierung mit Fremdatomen vom Typ N als diejenige erreicht wurde, welche bei dem ersten Bereich von Typ N vorgenommen wurde, und die Übergänge derart miteinander verbunden sind, daß der erste PN-Übergang direkt und der zweite PN-Übergang umgekehrt arbeitet.

10. Zener-Diode nach Anspruch 9, dadurch gekennzeichnet, daß der erste Bereich aus Silicium vom Typ N $2,4\times10^{18}$ Phosphoratome pro Kubikzentimeter enthält.

11. Zener-Diode nach Anspruch 9 oder 10, dadurch gekennzeichnet, daß der zweite Bereich aus Silicium vom Typ N $2,8\times10^{18}$ Phosphoratome pro Kubikzentimeter enthält.

12. Zener-Diode nach einem der Ansprüche 9 bis 11, dadurch gekennzeichnet, daß die diffundierten metallischen Fremdatome Goldatome sind.

13. Zener-Diode nach Anspruch 12, dadurch gekennzeichnet, daß die Konzentration der Goldatome $2\cdot10^{16}$ pro Kubikzentimeter beträgt.

**Claims**

1. Process for the manufacture of a temperature-compensated Zener diode, in which a first p-n junction (2) is produced by depositing by means of epitaxy a first substrate of p-type silicon on a first substrate of n-type silicon and then subjecting the junction to a diffusion of metal impurities, this diffusion being performed in the n region of the said junction, characterized in that there is separately produced a second p-n junction (4) by depositing by means of epitaxy a second substrate of p-type silicon on a second substrate of n-type silicon having a concentration of n-type impurities which is greater than that of the first substrate of n-type silicon, and in that the two p-n junctions are connected so that the first p-n junction can operate directly and that the second p-n junction can operate in reverse.

2. Process of manufacture according to Claim 1, characterized in that the metallic impurities are gold atoms.

3. Process of manufacture according to either of Claims 1 and 2, characterized in that the diffusion of the metallic impurities is performed at a temperature of between 1,000 and 1,200°C.

4. Process of manufacture according to Claim 3, characterized in that the temperature of diffusion is approximately 1,100°C.

5. Process of manufacture according to either of Claims 3 and 4, characterized in that the diffusion period is approximately 1 hour.

6. Process of manufacture according to any one of Claims 1 to 5, characterized in that the first and the second substrates of n-type silicon are produced so that they contain 2 to 3 $10^{18}$ phosphorus atoms per cubic centimetre.

7. Process of manufacture according to Claim 6, characterized in that the first substrate of n-type silicon contains 2.4 $10^{18}$ phosphorus atoms per cubic centimetre.

8. Process of manufacture according to either of Claims 6 and 7, characterized in that the second substrate of n-type silicon contains 2.8 $10^{18}$ phosphorus atoms per cubic centimetre.

9. Temperature-compensated Zener diode, comprising a first p-n junction comprising a first region consisting of p-type silicon and a first region consisting of n-type silicon, containing metallic impurities introduced by diffusion into the said n-type region, and a second p-n junction, characterized in that the second p-n junction comprises a second region of p-type silicon and a second region of n-type silicon, this second n-type region being produced by a doping with n-type impurities which is greater than that produced in the case of the first n-type region, the said junctions being connected to each other so that the first p-n junction can operate directly and that the second p-n junction can operate in reverse.

10. Zener diode according to Claim 9, characterized in that the first region of n-type silicon contains 2.4 $10^{18}$ phosphorus atoms per cubic centimetre.

11. Zener diode according to either of Claims 9 and 10, characterized in that the second region of n-type silicon contains 2.8 $10^{18}$ phosphorus atoms per cubic centimetre.

12. Zener diode according to any one of Claims 9 to 11, characterized in that the diffused metallic impurities are gold atoms.

13. Zener diode according to Claim 12, characterized in that the concentration of gold atoms is 2 $10^{16}$ atoms per cubic centimetre.

FIG. 1

FIG. 2

FIG. 3